# EUROPEAN PATENT APPLICATION

(11) **EP 4 704 516 A1**
(43) Date of publication of application: **04.03.2026**
(21) Application number: 24198070.5
(22) Date of filing: 03.09.2024
(51) Int. Cl.: H10D 30/01, H10D 30/47, H10D 62/10, H10D 62/80, H10D 64/27

(54) **TRANSISTOR DEVICE**

(71) Applicant: Huawei Technologies Co., Ltd., Shenzhen, Guangdong 518129 (CN)
(72) Inventor: Bhuwalka, Krishna Kumar, 80992 Munich (DE); Zhao, Wenbo, 80992 Munich (DE)
(74) Representative: Roth, Sebastian

(57) **Abstract**

In some examples, a transistor device comprises a source contact having a sidewall surface, a drain contact having a sidewall surface, and multiple functional units, wherein each one of the multiple functional units comprises a first channel layer extending between the sidewall surfaces of the source and drain contacts, the first channel layer comprising a 2D material, a first gate structure disposed over the first channel layer, wherein a dielectric layer is interposed between the first channel layer and the first gate structure, wherein the dielectric layer comprises a dielectric material, wherein the transistor device further comprises a first connection connecting each of the first gate structures of the multiple functional units from a top of the first gate structure, and a second connection connecting each of the first gate structures of the multiple functional units along a direction parallel to a plane of the first channel layer.

## Description

### TECHNICAL FIELD

The present disclosure relates, in general, to single-gate transistor devices. Aspects of the disclosure relate to manufacturing single-gate multi-stack transistor devices.

### BACKGROUND

In the fabrication of modern semiconductor integrated circuit devices, established processes such as film deposition, etch mask creation, patterning, material etching and removal, and doping treatments are commonly employed. These processes are often repeated to form the desired circuits on a substrate. However, the semiconductor industry has been grappling with the challenge of further miniaturising and enhancing the performance of integrated circuits, aiming to reduce power consumption while increasing operational speed. Traditionally, integrated circuits are fabricated in a single plane, with wiring or metallisation layers formed above or below the active device layer. These circuits are typically referred to as two-dimensional (2D) circuits. Although advancements in 2D circuit fabrication have historically increased the number of transistors per unit area, further improvements have plateaued as the feature sizes of individual transistors approach the physical limit of just a few nanometres. In response to this limitation, there is a growing demand among device manufacturers for innovative solutions.

### SUMMARY

An objective of the present disclosure is to provide a transistor device with enhanced current per footprint and improved capacitance.

The foregoing and other objectives are achieved by the features of the independent claims.

Further implementation forms are apparent from the dependent claims, the description and the Figures.

A first aspect of the present disclosure provides a transistor device comprising a source contact having a sidewall surface, a drain contact having a sidewall surface, and multiple functional units, wherein each one of the multiple functional units comprises a first channel layer extending between the sidewall surfaces of the source and drain contacts, the first channel layer comprising a 2D material, a first gate structure disposed over the first channel layer, wherein a dielectric layer is interposed between the first channel layer and the first gate structure, wherein the dielectric layer comprises a dielectric material, wherein the transistor device further comprises a first connection connecting each of the first gate structures of the multiple functional units from a top of the first gate structure, and a second connection connecting each of the first gate structures of the multiple functional units along a direction parallel to a plane of the first channel layer.

Accordingly, a transistor device with enhanced current per footprint and improved capacitance can be provided, effectively addressing the issue of non-scaling device. The proposed device overcomes these challenges by optimising the current flow relative to the device's footprint and enhancing capacitance, ensuring better overall performance even as dimensions are scaled down. This approach not only boosts efficiency but also mitigates the drawbacks associated with reduced carrier density in the channel, offering a more effective solution for next-generation semiconductor technologies.

Each one of the multiple functional unit may further comprise a second channel layer extending between the sidewall surfaces of the source and drain contacts, the second channel layer comprising the 2D material, wherein the second channel layer is disposed over the first gate structure.

The first gate structure may comprise a first gate insulator layer and a gate metal layer, wherein the first gate insulator layer is disposed on the gate metal layer.

The first gate structure may comprise a gate metal layer and a first gate insulator layer, wherein the gate metal layer is disposed on the first gate insulator layer.

The first gate structure may further comprise a second gate insulator layer disposed on the gate metal layer.

The first channel layer may comprise one or more layers.

The 2D material may comprise a transition metal dichalcogenide (TMDC).

The first channel may have a thickness in a range of 0.5 nanometres to 2.5 nanometres.

The first connection and/or the second connection may comprise a common inner gate arranged between the multiple functional units, wherein the common inner gate is arranged to connect each of the first gate structures of the multiple functional units.

A second aspect of the present disclosure provides a method for fabricating a transistor device, the method comprising providing a substrate, forming multiple functional units, wherein forming each one of the multiple functional units comprises: forming a first channel layer on the substrate, wherein the first channel comprises a first 2D material, forming a dielectric layer over the first channel layer, and forming a first gate structure over the dielectric layer, forming a first connection by depositing a layer of a gate material at a top of the first gate structure, wherein the first connection connects each of the first gate structures of the multiple functional units, and forming a second connection, whereby to connect each of the first gate structures of the multiple functional units along a direction parallel to a plane of the first channel layer.

The method may further comprise forming, on top of the first gate structure of a first functional unit of the multiple functional units, multiple top and side spacers, wherein the first functional unit of the multiple functional units comprises the functional unit most distal to the substrate, and exposing the first channel layer of the first functional unit by selectively etching at least the first gate structure of the first functional unit, wherein forming the first connection comprises depositing the layer of the gate material over the exposed first channel layer of the first functional unit, the layer of the gate material abutting the multiple top and side spacers.

The method may further comprise forming a source region and a drain region on respective sides of the multiple functional units by recessing the multiple functional units, forming a contact to the source region, whereby to provide a source contact, and forming a contact to the drain region, whereby to provide a drain contact, providing multiple recesses in the first gate structure of each of the multiple functional units, the multiple recesses proximate to the source and drain regions, and depositing a dielectric material in the multiple recesses, and depositing a metallic material in the source region and the drain region, whereby to form a source electrode and a drain electrode, respectively.

Forming each one of the multiple functional units may further comprise forming a second channel layer over the first gate structure, wherein the second channel layer comprises a second 2D material, wherein the second 2D material comprises the same material as the first 2D material or a material different from the first 2D material.

Forming the first gate structure may comprise forming a first gate insulator layer over a gate metal layer.

Forming the first gate structure may comprise forming a gate metal layer over a first gate insulator layer.

These and other aspects of the invention will be apparent from the embodiment(s) described below.

### BRIEF DESCRIPTION OF THE DRAWINGS

In order that the present invention may be more readily understood, embodiments of the invention will now be described, by way of example, with reference to the accompanying drawings, in which:
Figure 1 is a schematic representation of a transistor device according to an example;
Figure 2 is a schematic representation of a transistor device according to another example;
Figure 3 is a schematic representation of a transistor device according to yet another example;
Figures 4a-4h are schematic representations of a method of fabrication according to an example; and
Figure 5 is a flow chart of a method according to an example.

### DETAILED DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

2D-based devices have been leading the way in allowing Contacted Poly Pitch (CPP) scaling due to their excellent control over short-channel effects (SCE). The extremely thin nature of 2D materials, typically less than 1nm in thickness, inherently provides superior control over these effects, making them highly suitable for further scaling efforts.

Gate-all-around (GAA) nanosheet and nanosheet-based Complementary FET (CFET) architectures are prominent candidates for continued CPP and cell-height scaling. These structures offer potential benefits in terms of effective width per footprint scalability. The use of 2D channel materials in these architectures is extensively studied for highly scaled future CMOS technologies. However, despite their promise, GAA structures do not significantly enhance gate-length (CPP) scalability. This limitation is due to the fundamental characteristics of 2D materials, which, while offering excellent SCE control, suffer from a limited density of states and/or worse mobility. This limitation results in a reduced number of carriers in the channel, leading to a degradation in device performance. The present invention addresses the potential complexities associated with gate-all-around structures in 2D material-based devices, such as stacked nanosheets or 3D complementary field-effect transistor architectures. Contrary to the prevailing expectation that GAA structures represent the ultimate device architecture, this invention demonstrates that GAA configurations may not be required initially due to the inherent process complexities. Instead, this invention proposes that the enhanced short-channel effects observed in 2D materials can be effectively managed using single-gate stacked devices, providing a simplified and efficient alternative

Specifically, even though GAA architectures translates into better gate-length scalability, it may also result in overall performance degradation due to mobility degradation.. This degradation can manifest as an almost 15% drop in performance when normalised by the effective width of the transistor's channel. Despite this drawback, GAA-NS and CFET-based devices remain an obvious choice for the future of semiconductor technology due to their potential for high-density integration and reduced power consumption.

The prior art acknowledges the extensive study and deployment of GAA devices based on 2D-materials, particularly as all major foundries are transitioning towards GAA-based device architectures.. These advancements highlight the industry's commitment to exploring the full potential of 2D materials, despite the challenges posed by their inherent properties. 2D materials are replacing silicon (Si) materials, which are bulk-like, with extremely thin, sheet-like materials such as WX2, as previously defined. The ongoing research and development in this field aim to address the issues related to optimise the performance of GAA and CFET-based 2D material devices.

According to an example, there is provided a device with improved current per footprint and enhanced capacitance, which effectively addresses the problem of non-scaling current. Unlike traditional gate-all-around architectures, the present invention proposed to make 2D material based stacked devices without the need of making the GAA. By optimising the device's structure and materials, the invention manages to maintain performance, provide for lower capacitance and reduced process complexity, thereby ensuring better performance even as feature sizes are reduced. This improvement addresses the critical issue present in prior art, where the thinness of 2D materials, while advantageous for controlling short-channel effects, results in a decreased mobilty. The device according to the present invention ensures that current conduction is more efficient, capacitance is optimised, thus offering a significant advancement over GAA-based 2D devices.

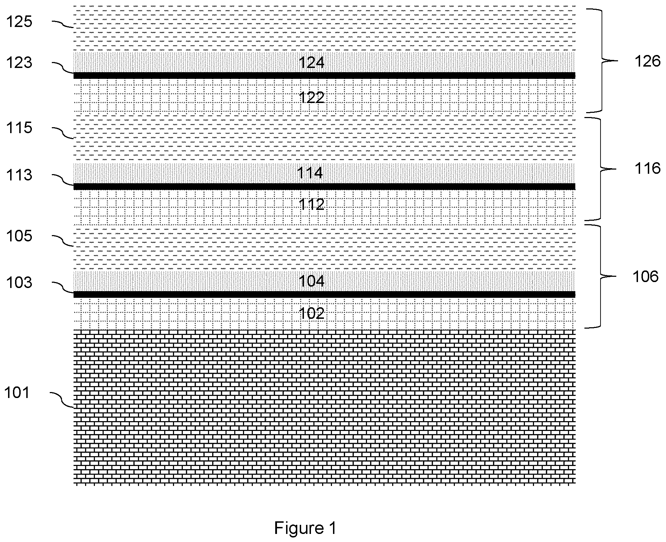

Figure 1 is a schematic representation of a transistor device according to an example. In particular, Figure 1 is a cross-sectional view showing a layout of the transistor device 100. The transistor device 100 comprises a source contact having a sidewall surface and a drain contact having a sidewall surface. The transistor device 100 also comprises multiple functional units, wherein each of the multiple functional units comprises a first channel layer extending between the sidewall surfaces of the source and drain contacts, a first gate structure disposed over the first channel layer, and a dielectric layer disposed between the first channel layer and the first gate structure.

Here, the term "functional unit" may refer to a single gate nanosheet (NS) device. The single gate NS device may lead to multi-stacked single gate NS devices, connected on either one or both sides in the width direction. In the channel direction, there is source-drains of the device. In other words, the transistor device 100 may comprise multiple single gate nanosheet stacked devices, connected on either one or both sides in the width direction.

As shown in Figure 1, the transistor device may comprise a substrate 101. The substrate may comprise any suitable semiconductor substrate, for example, a silicon substrate, or a dielectric substrate like SiO₂ or sapphire. The multiple functional units may be arranged in parallel to the substrate 101, with the drain and source contact extending orthogonal to the substrate 101.

In the example shown in Figure 1, a first dielectric layer 102 is disposed over the substrate 101, with a first channel layer 103 disposed over the first dielectric layer 102. The first dielectric layer 102 may serve to electrically isolate the first channel layer 103 from the substrate 101, preventing unwanted current leakage. The dielectric layer also serves as a 2D material growth or layer-transfer substrate. The first channel layer 103 may form the conductive path for charge carriers within the transistor device 100.

A first gate insulator layer 104 is disposed over the first channel layer 103, with a first gate metal layer 105 disposed over the first gate insulator layer 104. The first gate insulator layer 104 may serve to electrically insulate the first gate electrode from the channel, thereby controlling the flow of charge carriers in the first channel layer 103. The first gate insulator layer 104 may comprise a silicon-oxide layer or a high-k dielectric material, i.e., any material with a higher dielectric constant as compared to the silicon dioxide, or a combination of these materials. For example, high-k dielectric can include hafnium silicate, zirconium silicate, hafnium dioxide, zirconium dioxide, and others. The first gate metal layer 105 may act as the electrode through which a voltage is applied to control the electrical conductivity of the first channel layer 103. Together, the first gate insulator layer 104 and the gate metal layer 105 may form a first gate structure.

The first layers 102-105 (i.e., the dielectric layer 102, the channel layer 103, the gate insulator layer 104 and the gate metal layer 105) may form a functional unit 106 of the multiple functional units. The multiple functional units may be stacked on top of one another. In the example of Figure 1, three functional units 106, 116, 126 are shown, but the invention is not limited thereto.

As shown in Figure 1, a second dielectric layer 112 is disposed on top of the first gate metal layer 105 of the first functional unit 106, followed by a second channel layer 113, a second gate insulator layer 114, and a second gate metal layer 115 of the second functional unit 116 of the multiple functional units. Similarly to the first gate structure, a second gate structure may comprise the second gate insulator layer 114 and the second gate metal layer 115. The second dielectric layer 112 of the second functional unit 116 may function similarly to the first dielectric layer 102 of the first functional unit 106, separating the second channel layer 113 and the corresponding gate structures from the layers beneath, ensuring independent operation of the channel layers 103, 113, 123 and preventing electrical interference between them. It should however we noted that the multiple gates 105, 115, 125 are connected on one or both the sides along the width direction through the top gate extending on the sides.

In Figure 1, a third dielectric layer 122 of a third functional unit 126 is disposed over the second gate layer 115. A third channel layer 123 is disposed over the third dielectric layer 122, followed by a third gate insulator layer 124 and a third gate metal layer 125.

The first gate metal layer 105, the second gate metal layer 115, and the third gate metal layer 125 may collectively serve as the electrodes for controlling the electrical conductivity of their respective channel layers within the transistor device 100. Each gate metal layer may apply an electric field across the corresponding gate insulator layer, modulating the charge carrier concentration in the associated channel layer. The first gate metal layer 105 may be primarily responsible for controlling the first channel layer 103, while the second gate metal layer 115 controls the second channel layer 113. The third gate metal layer 125, disposed above the third channel layer 123, may function similarly to modulate the conductivity of the third channel layer 123. Additionally, the third gate metal layer 125 may serve as a top gate.

The top gate interconnects each of the gate metal layers. A side gate connection is also present, interconnecting the gate metal layers. The side gate connection interlinks the gate metal layers of the transistor device from the side, along the width direction of the stack. Here, the term "width direction" refers to a lateral dimension or axis that runs parallel to the plane of the layers and perpendicular to the stacking direction of the layers. Specifically, if the channel layers and gate layers are considered to be laid out horizontally, the width direction extends along the horizontal plane across the lateral extent of the device.

The top connection, also referred to as the top gate, is an electrical connection that unifies the gate metal layers from the top of the stack. Here, the term "top of the stack" refers to the uppermost surface or layer in the vertical sequence of layers. If the layers are considered to be arranged one above the other, starting from the substrate 101, the top of the stack is the final layer that is deposited or positioned at the highest point in the vertical arrangement. In the example of Figure 1, the third metal gate layer 125 is arranged at the top of the stack. In other words, the top of the stack is essentially the upper boundary of the vertically arranged series of layers.

The dielectric layer 102 may comprise a dielectric material. The dielectric material may comprise SiO2, sapphire, or similar substrate enabling transfer of 2D material.

The channel layer 103 comprises a two-dimensional (2D) material. The 2D material may encompass, but is limited to, compounds such as WS₂, WSe₂, WTe₂, MoS₂, MoSe₂, MoTe₂, HfS₂, ZrS₂, TiS₂, GaSe, InSe, phosphorene, and other comparable materials. These materials can be deposited using an atomic layer deposition (ALD) process, achieving a thickness of approximately 0.5 nanometres to 2.5 nanometres, thereby classifying them as 2D materials. Preferably, the 2D material may comprise a transition metal dichalcogenide. The first channel layer 103, the second channel layer 113 and the third channel layer 123 may comprise the same or different 2D material. Additionally, each of the channel layers may comprise monolayers, bilayers, or any other multiple layers of the same 2D material.

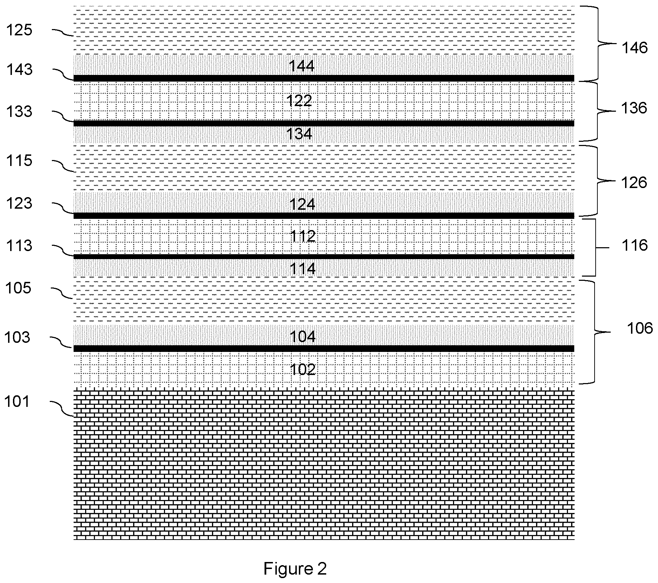

Figure 2 is a schematic representation of a transistor device according to another example. The transistor device 200 shown in Figure 2 largely corresponds to the transistor device 100 shown in Figure 1. The same elements in Figures 1 and 2 are denoted using the same reference numerals and function likewise. However, in contrast to Figure 1, the amount of functional units (i.e., single gate devices) is different.

In particular, Figure 2 shows a dielectric 101 with a first dielectric layer 102 disposed immediately over it. A first channel layer 103 is disposed over the first dielectric layer 102, with a first gate insulator layer 104 disposed over the first channel layer 103. A first gate metal layer 105 is disposed over the first gate insulator layer 104. Additionally, in contrast to the transistor device 100, a second gate insulator layer 114 is disposed over the gate metal layer 105.

In Figure 2, a second channel layer 113 is disposed over the second gate insulator layer 114. A second dielectric layer 112 is disposed over the second channel layer 113, followed by a third channel layer 123, with a third gate insulator layer 124 disposed over the third channel layer 123. A second gate metal layer 115 is sandwiched between the third gate insulator layer 124 and a fourth gate insulator layer 134. A fourth channel layer 133 is disposed over the fourth gate insulator layer 134, having a third dielectric layer 122 disposed over the fourth channel layer 133. The third dielectric layer 122 separates the fourth channel layer 133 from a fifth channel layer 143. A fifth gate insulator layer 144 is disposed over the fifth channel layer 143, with a third gate metal layer 125 disposed over the fifth gate insulator layer 144. Similarly to the transistor device 100, the third gate metal layer 125 of the transistor device 200 may act as the top gate.

Similar to the transistor device 100, the transistor device 200 comprises multiple functional units, i.e., single gate nanosheet stacked devices, each formed by specific combinations of channel layers, gate insulator layers, and gate metal layers. The first functional unit 106 includes first channel layer 103, first gate insulator layer 104, and first gate metal layer 105. The second functional unit 116 comprises the second channel layer 113, the second gate insulator layer 114, and the second dielectric layer 112. The third functional unit 126 comprises the third channel layer 123, the third gate insulator layer 124, and the second gate metal layer 115. The fourth functional unit 136 comprises the fourth channel layer 133, the fourth gate insulator layer 134, and the third dielectric layer 122, which separates the fourth channel layer 133 from the fifth channel layer 143. The fifth functional unit 146 comprises the fifth channel layer 143, the fifth gate insulator layer 144, and the third gate metal layer 125.

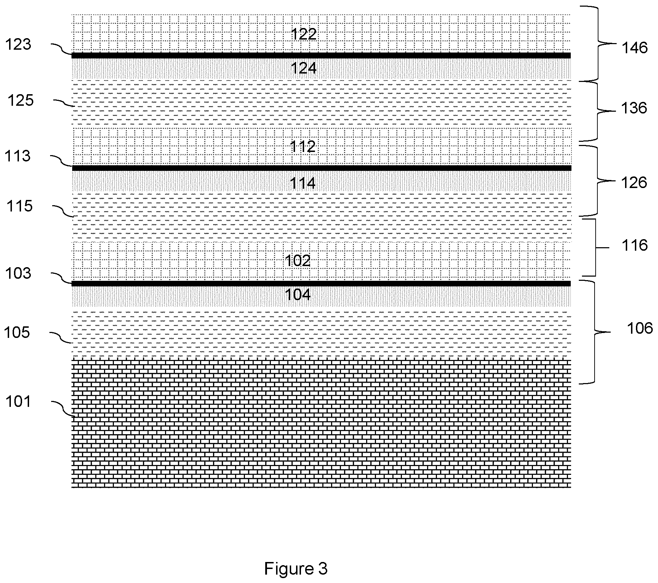

Figure 3 is a schematic representation of a transistor device according to yet another example. The transistor device 300 shown in Figure 3 largely corresponds to the transistor device 100 shown in Figure 1, as well as the transistor device 200 shown in Figure 2. The same elements in Figures 1-3 are denoted using the same reference numerals and function likewise.

Figure 3 shows a dielectric 101 having a first gate metal layer 105 disposed over it. A first gate insulator layer 104 is disposed over the first gate metal layer 105, having a first channel layer 103 disposed over the first gate insulator layer 104. A first dielectric layer 102 is disposed over the first channel layer 103. These layers form the first functional unit 106 (i.e., single gate device) of the multiple functional units.

A second gate metal layer 115 is disposed over the first dielectric layer 102. A second gate insulator layer 114 is disposed over the second gate metal layer 115, with a second channel layer 113 disposed over the second gate insulator layer 114. A second dielectric layer 112 is disposed over the second channel layer 113. A third gate metal layer 125 is sandwiched between the second dielectric layer 112 and a third gate insulator layer 124. A third channel layer 123 is disposed over the third gate insulator layer 124. A third dielectric layer 122 is disposed over the third channel layer 123.

The first functional unit 106 comprises the first gate metal layer 105, the first gate insulator layer 104, the first channel layer 103 and the first dielectric layer 102. The second functional unit 116 comprises the second gate metal layer 115, the second gate insulator layer 114, the second channel layer 113 and the second dielectric layer 112. The third functional unit comprises the third gate metal layer 125, the third gate insulator layer 124, the third channel layer 123 and the third dielectric layer 122.

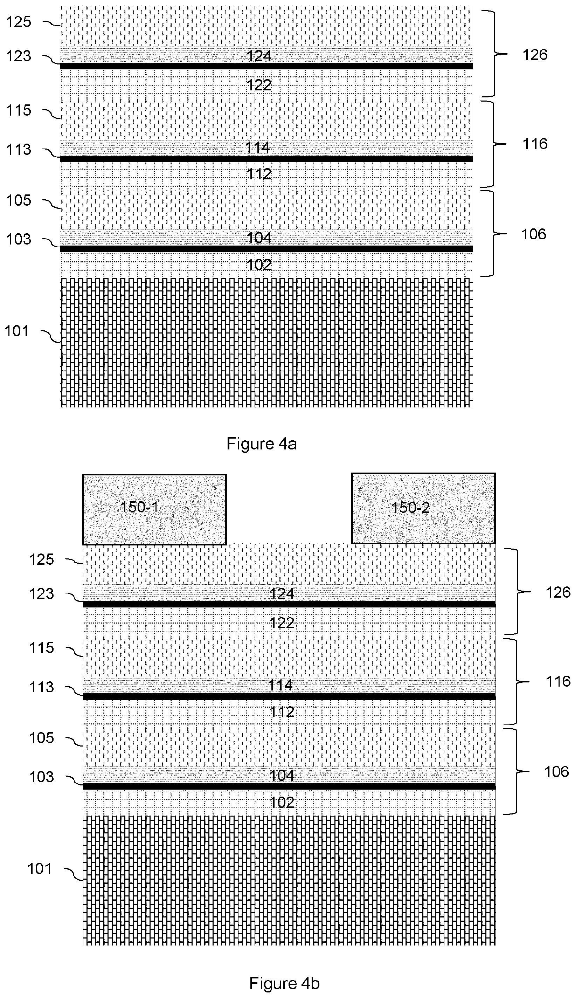

Figures 4a-4h are schematic representations of a method of fabrication according to an example. In particular, the method of fabrication relates to the method of fabrication of the transistor device as described above in relation to Figures 1-3. As such, the same reference numerals are used to denote the same elements, functioning likewise.

Figure 4a shows the multiple functional units deposited on a substrate. While the arrangement of the layers (and therefore the functional units) shown in Figure 4a corresponds to the embodiment described above in relation to Figure 1, the invention is not limited thereto, and the same method of fabrication can be used to manufacture the transistor device employing any arrangement of the layers according to the invention.

The process may begin with the preparation of the substrate 101, which may comprise a silicon substrate or a suitable dielectric substrate. The first dielectric layer 102 may be deposited over the substrate 101. This deposition can be achieved through various methods such as chemical vapour deposition (CVD), atomic layer deposition (ALD), or thermal oxidation, depending on the material properties desired. Following the formation of the first dielectric layer 102, a first channel layer 103 may be deposited. This layer, comprising a two-dimensional material like MoS₂ or other similar materials, can be deposited using techniques such as molecular beam epitaxy (MBE), CVD, or physical vapour deposition (PVD).

Subsequently, a first gate insulator layer 104, comprising a high-k dielectric material, may be deposited over the first channel layer 103. The high-k material may be deposited, for example, using ALD. A first gate metal layer 105 may then be deposited over the first gate insulator layer 104, forming the first gate structure (i.e., gate electrode). This layer can be deposited by sputtering, evaporation, or CVD, depending on the choice of metal and the desired deposition properties.

The steps described above are repeated for each subsequent functional unit in the stack, with second and third dielectric layers 112 and 122, second and third channel layers 113 and 123, second and third gate insulator layers 114 and 124, and second and third gate metal layers 115 and 125, respectively, following similar fabrication processes.

Figure 4b depicts the formation of the top/side spacers 150-1 and 150-2. The top/side spacers 150-1 and 150-2 may be arranged to isolate the gate structures from the source and drain regions, as well as from each other, thereby preventing leakage. The top/side spacers 150-1, 150-2 may comprise a dielectric material such as silicon nitride or silicon dioxide, or SiCO, or a low-k spacer containing an air-gap. The spacers can be deposited or formed using methods such as CVD or ALD. While not shown in the figure, the top/side spacers 150-1, 150-2 may be arranged on the sidewalls the gate structures and the source/drain contacts.

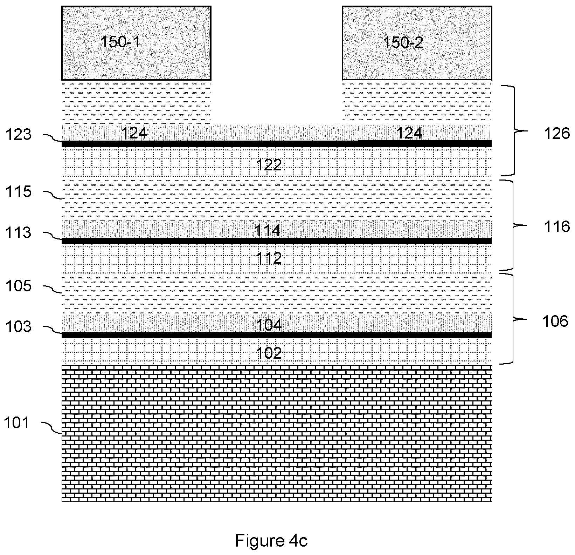

Once the spacers have been provided, a portion of the top gate - i.e., the third gate metal layer 125 - may be selectively removed, whereby to expose the underlying layers. This is shown in Figure 4c. The third gate metal layer 125 may comprise a temporary or sacrificial gate structure that was initially deposited to facilitate earlier stages of the device fabrication process, e.g., to define a region where the top/side gate will later be formed. Once it has served its purpose, the temporary gate is removed to make space for the top/side gate to later be deposited.

The removal process may involve photolithography to define the portion of third gate metal layer 125 should be removed. Subsequently, either dry etching or wet etching can be employed to remove the desired portion of the third gate metal layer 125. During the etching process, care must be taken to ensure that the underlying layers, particularly the third gate insulator layer 124 and third channel layer 123, are not damaged or altered.

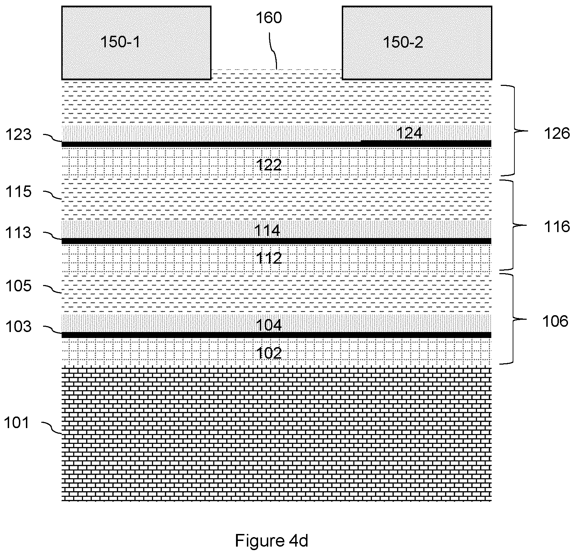

Figure 4d depicts the deposition of the top/side gate 160, which forms the final, permanent gate structure responsible for actively controlling the transistor's operation. Unlike the third gate metal layer 125, the top/side gate 160 wraps around the channel layers from both the top and sides, thereby connecting each gate metal layer of the multiple functional units along the width direction, as well as around the height direction. Notably, layer 160 connects all the previously formed inner gates, such as layers 115 and 105, from the side to form a single cohesive device. The side gates may be positioned on both sides or, alternatively, on only one side. The deposition of the top/side gate may include the deposition of a dielectric layer to insulate the gate from the third channel layer 123, followed by the deposition of a gate metal layer that serves as the electrode.

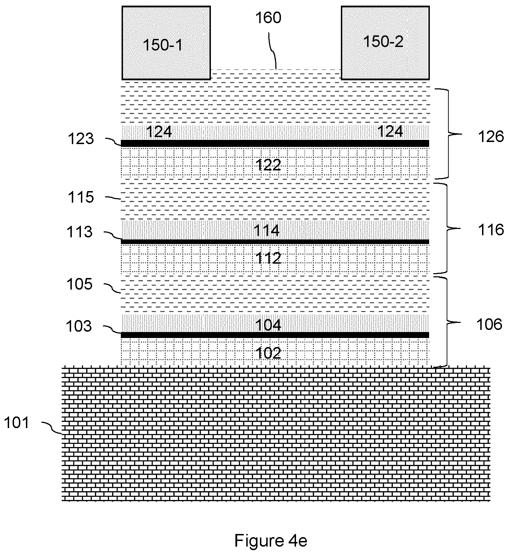

In Figure 4e depicts recessing of regions for source/drain formation and subsequent contact creation. This recessing may start with the precise etching of the semiconductor stack to define the locations where the source and drain contacts will be formed. Using photolithography, a mask may be applied to delineate the areas to be recessed, protecting the regions that should remain intact. Anisotropic etching, such as reactive ion etching (RIE), can be employed to ensure that the etched profiles are vertical and well-defined. The etching may selectively remove material from the designated regions down to a predetermined depth, sufficient to expose the appropriate layers for contact formation without damaging the underlying structures.

Once the recesses for the S/D regions have been formed, contact materials may be deposited into these recessed areas. The contact materials may comprise metals such as titanium, cobalt, nickel, or platinum. The contact metals can be deposited using techniques such as sputtering, evaporation, or CVD. After deposition, a planarisation process, such as chemical mechanical polishing (CMP), may be performed to remove excess metal and ensure that the contacts are flush with the surface.

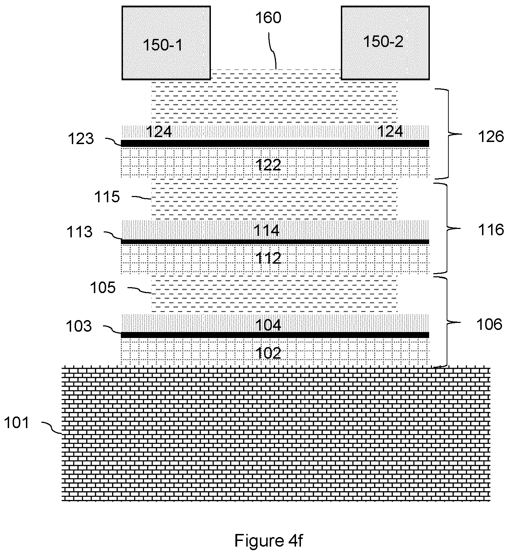

Figure 4f depicts the selective removal of the gate metal for spacer formation. This step may involve further photolithographic patterning to define the regions where the gate metal will be removed, whereby to create space around the gate structures for the spacers to be formed. The selective removal of the gate metal from the predefined portions of the gate metal layers may be achieved using any suitable etching technique, for example, using dry etching or wet etching.

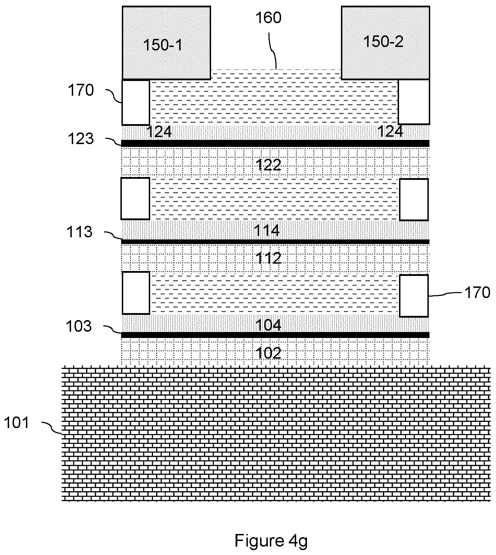

Figure 4g depicts the formation of spacer regions 170, arranged to separate the gate metal layers from the source/drain regions that will be formed at a later step. The formation of the spacer regions 170 may involve depositing a dielectric material in the space designated for the spacers, i.e., on the sidewalls of the gate structures. Deposition of the dielectric material may comprise CVD or ALD. The spacers 170 may be arranged to effectively separate the gate electrodes from the source/drain regions.

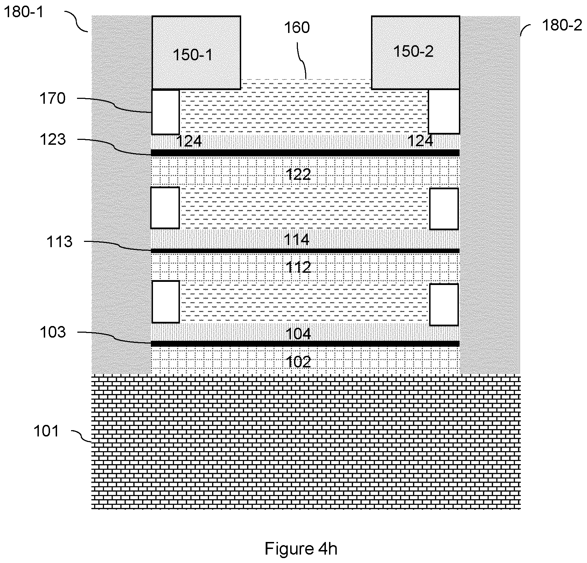

Finally, Figure 4h depicts the formation of the source/drain regions 180-1, 180-2 within the regions recessed during the step depicted in Figure 4e. The process may involve depositing a conducting metal into the previously created recesses. The conducting metal may comprise, for example, tungsten, cobalt, or titanium. The conducting metal may be deposited using techniques such as PVD, CVD, or electroplating. Following the deposition, planarisation may be performed, whereby to remove any excess metal. The formation of the source/drain electrodes 180-1, 180-2 enables the connection of the channel layers to the external circuitry. Subsequent processing steps may include annealing to improve the electrical properties, the application of passivation layers to protect the device, and the formation of interconnects to integrate the transistor into a larger circuit.

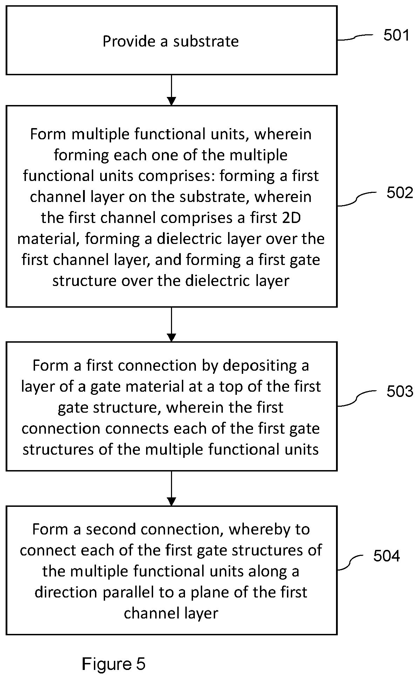

Figure 5 is a flow chart of a method according to an example. The method relates to a method for fabricating a transistor device as described herein, i.e., the transistor device shown and described in relation to Figures 1-4. The method comprises, in block 501, providing a substrate. In block 502, the method comprises forming multiple functional units, wherein forming each one of the multiple functional units comprises: forming a first channel layer on the substrate, wherein the first channel comprises a first 2D material, forming a dielectric layer over the first channel layer, and forming a first gate structure over the dielectric layer. In block 503, the method comprises forming a first connection by depositing a layer of a gate material at a top of the first gate structure, wherein the first connection connects each of the first gate structures of the multiple functional units. The method comprises, in block 504, forming a second connection, whereby to connect each of the first gate structures of the multiple functional units along a direction parallel to a plane of the first channel layer.

The preceding description has been provided to enable others skilled in the art to best utilize various aspects of the exemplary embodiments disclosed herein. This exemplary description is not intended to be exhaustive or to be limited to any precise form disclosed. Many modifications and variations are possible without departing from the spirit and scope of the instant disclosure. The embodiments disclosed herein should be considered in all respects illustrative and not restrictive. Reference should be made to the appended claims and their equivalents in determining the scope of the instant disclosure.

## Claims

1. A transistor device (100) comprising:
a source contact (180-1, 180-2) having a sidewall surface;
a drain contact (180-1, 180-2) having a sidewall surface; and
multiple functional units (106, 116, 126), wherein each one of the multiple functional units (106, 116, 126) comprises:
a first channel layer (103, 113, 123) extending between the sidewall surfaces of the source and drain contacts (180-1, 180-2), the first channel layer (103, 113, 123) comprising a 2D material;
a first gate structure disposed over the first channel layer (103, 113, 123),
wherein a dielectric layer (102, 112, 122) is interposed between the first channel layer (103, 113, 123) and the first gate structure, wherein the dielectric layer (102, 112, 122) comprises a dielectric material;
wherein the transistor device further comprises a first connection (160) connecting each of the first gate structures of the multiple functional units (106, 116, 126) from a top of the first gate structure, and a second connection connecting each of the first gate structures of the multiple functional units (105, 115, 125) along a direction parallel to a plane of the first channel layer (103, 113, 123).

2. The transistor device of claim 1, wherein each one of the multiple functional units (106, 116, 126) further comprises:
a second channel layer extending between the sidewall surfaces of the source and drain contacts, the second channel layer comprising the 2D material, wherein the second channel layer is disposed over the first gate structure.

3. The transistor device of claim 1 or 2, wherein the first gate structure comprises a first gate insulator layer (104, 114, 124) and a gate metal layer (105, 115, 125), wherein the first gate insulator layer (104, 114, 124) is disposed on the gate metal layer (105, 115, 125).

4. The transistor device of claim 1 or 2, wherein the first gate structure comprises a gate metal layer (105, 115, 125) and a first gate insulator layer (104, 114, 124), wherein the gate metal layer (105, 115, 125) is disposed on the first gate insulator layer (104, 114, 124).

5. The transistor device of claim 4, wherein the first gate structure further comprises a second gate insulator layer disposed on the gate metal layer (105, 115, 125).

6. The transistor device of any one of claims 1 to 5, wherein the first channel layer (103, 113, 123) comprises one or more layers.

7. The transistor device of any one of claims 1 to 6, wherein the 2D material comprises a transition metal dichalcogenide (TMDC).

8. The transistor device of any one of claims 1 to 7, wherein the first channel layer (103, 113, 123) has a thickness in a range of 0.5 nanometres to 2.5 nanometres.

9. The transistor device of any one of claims 1 to 7, wherein the first connection and/or the second connection comprises a common inner gate arranged between the multiple functional units (106, 116, 126), wherein the common inner gate is arranged to connect each of the first gate structures of the multiple functional units.

10. A method for fabricating a transistor device, the method comprising:
providing a substrate (501);
forming multiple functional units, wherein forming each one of the multiple functional units comprises: forming a first channel layer on the substrate, wherein the first channel comprises a first 2D material, forming a dielectric layer over the first channel layer, and forming a first gate structure over the dielectric layer (502);
forming a first connection by depositing a layer of a gate material at a top of the first gate structure, wherein the first connection connects each of the first gate structures of the multiple functional units (503); and
forming a second connection, whereby to connect each of the first gate structures of the multiple functional units along a direction parallel to a plane of the first channel layer (504).

11. The method of claim 10, further comprising:
forming, on top of the first gate structure of a first functional unit of the multiple functional units, multiple top and side spacers, wherein the first functional unit of the multiple functional units comprises the functional unit most distal to the substrate; and
exposing the first channel layer of the first functional unit by selectively etching at least the first gate structure of the first functional unit,
wherein forming the first connection (503) comprises depositing the layer of the gate material over the exposed first channel layer of the first functional unit, the layer of the gate material abutting the multiple top and side spacers.

12. The method of claim 10 or 11, further comprising:
forming a source region and a drain region on respective sides of the multiple functional units by recessing the multiple functional units;
forming a contact to the source region, whereby to provide a source contact, and forming a contact to the drain region, whereby to provide a drain contact;
providing multiple recesses in the first gate structure of each of the multiple functional units, the multiple recesses proximate to the source and drain regions, and depositing a dielectric material in the multiple recesses; and
depositing a metallic material in the source region and the drain region, whereby to form a source electrode and a drain electrode, respectively.

13. The method of claim 10, 11 or 12, wherein forming each one of the multiple functional units (502) further comprises forming a second channel layer over the first gate structure, wherein the second channel layer comprises a second 2D material, wherein the second 2D material comprises the same material as the first 2D material or a material different from the first 2D material.

14. The method of any one of claims 10 to 13, wherein forming the first gate structure comprises forming a first gate insulator layer over a gate metal layer.

15. The method of any one of claims 10 to 13, wherein forming the first gate structure comprises forming a gate metal layer over a first gate insulator layer.

## Amended claims

### Amended claims in accordance with Rule 137(2) EPC.

1. A transistor device (100) comprising:
a source contact (180-1, 180-2) having a sidewall surface;
a drain contact (180-1, 180-2) having a sidewall surface; and
a stack of multiple functional units (106, 116, 126) that are vertically stacked on top of one another, wherein each one of the multiple functional units (106, 116, 126) comprises:
a first channel layer (103, 113, 123) extending between the sidewall surfaces of the source and drain contacts (180-1, 180-2), the first channel layer (103, 113, 123) comprising a 2D material;
a first gate structure disposed over the first channel layer (103, 113, 123),
wherein a dielectric layer (102, 112, 122) is interposed between the first channel layer (103, 113, 123) and the first gate structure, wherein the dielectric layer (102, 112, 122) comprises a dielectric material;
wherein the transistor device further comprises a first connection (160) connecting each of the first gate structures of the multiple functional units (106, 116, 126) from a top of the first gate structure of the topmost functional unit (126), and a second connection extending along a direction that is parallel to a plane of the first channel layer (103, 113, 123), and connecting each of the first gate structures of the multiple functional units (105, 115, 125) from the side of the stack.

2. The transistor device of claim 1, wherein the first gate structure comprises a first gate insulator layer (104, 114, 124) and a gate metal layer (105, 115, 125), wherein the first gate insulator layer (104, 114, 124) is disposed on the gate metal layer (105, 115, 125).

3. The transistor device of claim 1, wherein the first gate structure comprises a gate metal layer (105, 115, 125) and a first gate insulator layer (104, 114, 124), wherein the gate metal layer (105, 115, 125) is disposed on the first gate insulator layer (104, 114, 124).

4. The transistor device of claim 3, wherein the first gate structure further comprises a second gate insulator layer disposed on the gate metal layer (105, 115, 125).

5. The transistor device of any one of claims 1 to 4, wherein the first channel layer (103, 113, 123) comprises one or more layers.

6. The transistor device of any one of claims 1 to 5, wherein the 2D material comprises a transition metal dichalcogenide (TMDC).

7. The transistor device of any one of claims 1 to 6, wherein the first channel layer (103, 113, 123) has a thickness in a range of 0.5 nanometres to 2.5 nanometres.

8. The transistor device of any one of claims 1 to 6, wherein the first connection comprises a top gate formed at the uppermost surface of the stack and configured to electrically interconnect the gate metal layers of the multiple functional units from the top; and/or wherein the second connection comprises a side gate extending along the direction that is parallel to the plane of the first channel layer, and configured to electrically connect each of the gate metal layers of the multiple functional units from the side of the stack.

9. A method for fabricating a transistor device, the method comprising:
providing a substrate (501);
forming a stack of multiple functional units that are vertically stacked on top of one another, wherein forming each one of the multiple functional units comprises: forming a first channel layer on the substrate, wherein the first channel comprises a first 2D material, forming a dielectric layer over the first channel layer, and forming a first gate structure over the dielectric layer (502);
forming a first connection by depositing a layer of a gate material at a top of the first gate structure of the topmost functional unit (126), wherein the first connection connects each of the first gate structures of the multiple functional units (503); and
forming a second connection extending along a direction that is parallel to a plane of the first channel layer, whereby to connect each of the first gate structures of the multiple functional units from the side of the stack.

10. The method of claim 9, further comprising:
forming, on top of the first gate structure of a first functional unit of the multiple functional units, multiple top and side spacers, wherein the first functional unit of the multiple functional units comprises the functional unit most distal to the substrate; and
exposing the first channel layer of the first functional unit by selectively etching at least the first gate structure of the first functional unit,
wherein forming the first connection (503) comprises depositing the layer of the gate material over a dielectric layer insulating the exposed first channel layer of the first functional unit, the layer of the gate material abutting the multiple top and side spacers.

11. The method of claim 9 or 10, further comprising:
forming a source region and a drain region on respective sides of the multiple functional units by recessing the multiple functional units;
forming a contact to the source region, whereby to provide a source contact, and forming a contact to the drain region, whereby to provide a drain contact;
providing multiple recesses in the first gate structure of each of the multiple functional units, the multiple recesses proximate to the source and drain regions, and depositing a dielectric material in the multiple recesses; and
depositing a metallic material in the source region and the drain region, whereby to form a source electrode and a drain electrode, respectively.

12. The method of any one of claims 9 to 11, wherein forming the first gate structure comprises forming a first gate insulator layer over a gate metal layer.

13. The method of any one of claims 9 to 12, wherein forming the first gate structure comprises forming a gate metal layer over a first gate insulator layer.
